# EUROPÄISCHE PATENTSCHRIFT

(11) **EP 3 298 866 B1**
(45) Veröffentlichungstag und Bekanntmachung des Hinweises auf die Patenterteilung: **29.01.2020**
(21) Anmeldenummer: 16715295.8
(22) Anmeldetag: 08.04.2016
(51) Int. Cl.: H05K 7/14

(54) **ELEKTRISCHE KONTAKTANORDNUNG**
ELECTRIC CONTACT ARRANGEMENT
ENSEMBLE DE CONTACT ÉLECTRIQUE

(30) Priorität: 21.05.2015 DE 102015209279
(43) Veröffentlichungstag der Anmeldung: 28.03.2018
(73) Patentinhaber: Robert Bosch GmbH, 70442 Stuttgart (DE)
(72) Erfinder: BREUNING, Christian, 72622 Nuertingen (DE)
(86) Internationale Anmeldenummer: PCT/EP2016/057695
(87) Internationale Veröffentlichungsnummer: WO 2016/184606

(56) Entgegenhaltungen:
- EP-A1- 1 359 662
- EP-A2- 2 015 626
- US-A1- 2009 059 637

## Beschreibung

### Stand der Technik

Die vorliegende Erfindung betrifft eine elektrische Kontaktanordnung. Die Kontaktanordnung wird insbesondere in einem Kraftfahrzeug verwendet.

Der Stand der Technik kennt im Kraftfahrzeugbereich unterschiedliche Gehäuse, in denen beispielsweise Steuergeräte, Leistungselektronik oder Energiespeicher angeordnet sind. Zum Anschluss dieser Bauteile im Gehäuse ragt üblicherweise ein Anschlussbolzen durch das Gehäuse. Die äußere Seite des Anschlussbolzens wird über einen entsprechenden Leiter mit dem Bordnetz verbunden. Die Durchführung des Bolzens durch das Gehäuse muss zumindest flüssigkeitsdicht sein und entsprechend elektrisch isoliert werden.

Aus dem Stand der Technik ist aus der EP 1 359 662 A1 eine elektrische Kontaktanordnung mit einem Gehäuse bekannt, wobei in eine Aussparung im Gehäuse eine Buchse eingesetzt ist, wobei in der Buchse ein Kontaktbolzen fest angeordnet ist und durch die Buchse hindurchragt, wobei die Buchse eine axiale Dichtfläche im Inneren des Gehäuses und zwei senkrecht zur Axialrichtung verlaufende Ansätze außerhalb des Gehäuses aufweist. In der EP 1 359 662 A1 ist ein Befestigungselement, das zum Aufliegen auf dem Gehäuse und zum Einschieben unter die Absätze ausgebildet ist, gezeigt.

### Offenbarung der Erfindung

Die erfindungsgemäße elektrische Kontaktanordnung zeigt eine kostengünstig herstellbare und einfach zu montierende Anordnung für den Kontaktbolzen am Gehäuse. Zum Anpressen der entsprechenden Dichtflächen bedarf es keiner geschraubten Verbindung. Lediglich durch Einschieben eines Befestigungselements erfolgt die Befestigung. Dieses Einschieben kann auch seitlich am Gehäuse oder an unzugänglichen Stellen erfolgen. Dies wird erfindungsgemäß erreicht durch die elektrische Kontaktanordnung, umfassend ein Gehäuse. In dem Gehäuse befindet sich eine Aussparung. Die Aussparung ist insbesondere ein kreisförmiges Loch. In die Aussparung wird der Kontaktbolzen eingesetzt. So definieren die Aussparung und der Kontaktbolzen eine Axialrichtung. Die erfindungsgemäße Kontaktanordnung umfasst des Weiteren eine in die Aussparung eingesetzte Buchse. Die Buchse weist eine axiale Dichtfläche auf. Die axiale Dichtfläche befindet sich im Inneren des Gehäuses. Außerhalb des Gehäuses verlaufen an der Buchse zwei Absätze. Insbesondere sind die Absätze jeweils durch Nuten gebildet. Diese zwei Absätze sind senkrecht zur Axialrichtung angeordnet. In der Buchse befindet sich der Kontaktbolzen. Dadurch ragen sowohl der Kontaktbolzen als auch die Buchse vom Inneren des Gehäuses nach außen. Die elektrische Kontaktanordnung umfasst des Weiteren ein Befestigungselement. Das Befestigungselement wird unter die Absätze, insbesondere in die Nuten, eingeschoben und liegt dabei auf dem Gehäuse auf. Das Befestigungselement befindet sich also außerhalb des Gehäuses und wird senkrecht zur Axialrichtung bewegt. Zwischen der Buchse und dem Befestigungselement sind keilförmige Flächen ausgebildet. Diese keilförmigen Flächen können auch als geneigte Flächen bezeichnet werden. Diese Flächen sind dabei bezüglich der Axialrichtung geneigt. Durch Einschieben des Befestigungselementes und aufgrund dieser keilförmigen Flächen wird die Buchse nach außen gezogen. Dadurch presst sich die Dichtfläche von Innen an das Gehäuse und schließt dicht ab. In der bevorzugten Variante sind die keilförmigen bzw. geneigten Flächen zwischen der Buchse und dem Befestigungselement ausgebildet. Zusätzlich oder alternativ ist es jedoch auch möglich, diese Flächen zwischen dem Gehäuse und dem Befestigungselement anzuordnen. Entscheidend ist, dass durch Einschieben des Befestigungselementes die Buchse nach außen gezogen wird und somit die Dichtfläche von Innen in das Gehäuse gepresst wird.

Die Unteransprüche zeigen bevorzugte Weiterbildungen der Erfindung.

Das Befestigungselement ist vorteilhafterweise gabelförmig ausgestaltet. Dies bedeutet, dass das Befestigungselement zwei parallele Finger aufweist. Die beiden Finger sind über eine Basis miteinander fest verbunden. Insbesondere ist das Befestigungselement ein einstückig gefertigtes Bauteil, beispielsweise aus Kunststoff. Die beiden parallelen Finger werden unter die beiden parallelen Absätze bzw. in die Nuten eingeschoben. Durch dieses einstückige gabelförmige Befestigungselement ist die Montage sehr einfach gestaltet, da ein Befestigungselement für beide Nuten eingesetzt wird. Aufgrund der beiden parallelen Nuten, die sich auf beiden Seiten der Achse befinden, wird die Buchse gleichmäßig in Axialrichtung gezogen und die Dichtfläche presst sich gleichmäßig von Innen gegen das Gehäuse.

Besonders bevorzugt sind die keilförmigen Flächen auf den Fingern des Befestigungselementes und an den Absätzen ausgebildet. Die keilförmigen bzw. geneigten Flächen an den Absätzen liegen entsprechend den keilförmigen bzw. geneigten Flächen auf den Fingern gegenüber.

Des Weiteren ist bevorzugt vorgesehen, dass der Kontaktbolzen durch einen Formschluss verdrehsicher in der Buchse angeordnet ist. Hierzu wird insbesondere die Buchse aus Kunststoff hergestellt. Der Kontaktbolzen ist dabei vom Kunststoff der Buchse umspritzt. Für den Formschluss zwischen Kontaktbolzen und Buchse weist der Kontaktbolzen vorteilhafterweise einen Mehrkant auf. Dieser Mehrkant wird umspritzt.

Darüber hinaus ist vorteilhafterweise vorgesehen, dass auch eine Bewegung des Kontaktbolzens gegenüber der Buchse in Axialrichtung aufgrund eines Formschlusses vermieden wird. Hierzu weist der Kontaktbolzen vorteilhafterweise eine Verjüngung auf. Diese Verjüngung wird vom Kunststoff der Buchse umspritzt.

Darüber hinaus ist vorteilhafterweise vorgesehen, dass das Befestigungselement durch einen Formschluss verdrehsicher am Gehäuse anliegt. Beispielsweise eine oder zwei Schultern seitlich des Befestigungselementes können für diesen Formschluss sorgen.

Das aus dem Gehäuse ragende Ende des Kontaktbolzens weist vorteilhafterweise ein Gewinde auf. Auf den Kontaktbolzen wird beispielsweise ein Polschuh aufgesetzt. Dieser Polschuh kann über eine Mutter fixiert werden. Aufgrund der verdrehsicheren Anordnung des Kontaktbolzens innerhalb der Buchse und aufgrund der verdrehsicheren Anordnung des Befestigungselementes wird ein beim Aufschrauben der Mutter auftretendes Drehmoment am Gehäuse abgestützt. Die Abdichtung zwischen Buchse und Gehäuse ist somit nicht durch dieses Moment belastet.

Darüber hinaus ist bevorzugt vorgesehen, dass eine Neigung der keilförmigen Flächen für einen selbsthemmenden Halt des Befestigungselements gewählt ist. Entsprechend den gewählten Materialpaarungen kann hier der nötige Winkel für die Neigung der keilförmigen Flächen berechnet oder im Versuch ermittelt werden. Aufgrund dieser selbsthemmenden Wirkung kann das Befestigungselement nicht von selbst aus den Nuten gleiten. Insbesondere liegt der Winkel zwischen den keilförmigen Flächen und der Axialrichtung zwischen 95° und 120°.

Zusätzlich oder alternativ zur selbsthemmenden Ausgestaltung der Neigung ist bevorzugt eine Rastverbindung zwischen dem Befestigungselement und dem Gehäuse vorgesehen. Hierbei rastet insbesondere eine Zunge des Befestigungselementes hinter einer gehäusefesten Nase ein. Diese Rastverbindung dient zur Fixierung des eingeschobenen Befestigungselementes.

Auf der Dichtfläche der Buchse ist vorteilhafterweise eine Dichtung angeordnet. Diese Dichtung ist insbesondere ringförmig. Zusätzlich oder alternativ kann diese Dichtung auch gehäuseseitig angeordnet werden. Insbesondere handelt es sich hier um eine Gummidichtung.

Die Erfindung umfasst des Weiteren eine Anordnung für ein Fahrzeug. Diese Anordnung weist zumindest eine elektrische Kontaktanordnung auf, wie sie soeben beschrieben wurde. In dem Gehäuse sind dabei ein Steuergerät, eine Leistungselektronik, ein Energiespeicher und/oder eine elektrische Maschine angeordnet. Der Kontaktbolzen ist dabei insbesondere ein 12 V- oder 24 V-Kontaktbolzen zum Anschluss an das Bordnetz des Fahrzeuges.

Die im Rahmen der elektrischen Kontaktanordnung beschriebenen Unteransprüche und vorteilhaften Ausgestaltungen finden entsprechend vorteilhafte Anwendung auf die erfindungsgemäße Anordnung für das Kraftfahrzeug.

### Kurze Beschreibung der Zeichnung

Nachfolgend wird ein Ausführungsbeispiel der Erfindung unter Bezugnahme auf die begleitende Zeichnung im Detail beschrieben. In der Zeichnung zeigt:
- Figur 1: eine erfindungsgemäße elektrische Kontaktanordnung gemäß einem Ausführungsbeispiel,
- Figur 2 und 3: Details der erfindungsgemäßen elektrischen Kontaktanordnung gemäß dem Ausführungsbeispiel,
- Figur 4: eine erste Schnittansicht der erfindungsgemäßen elektrischen Kontaktanordnung gemäß dem Ausführungsbeispiel, und
- Figur 5: eine zweite Schnittansicht der erfindungsgemäßen elektrischen Kontaktanordnung gemäß dem Ausführungsbeispiel.

### Ausführungsform der Erfindung

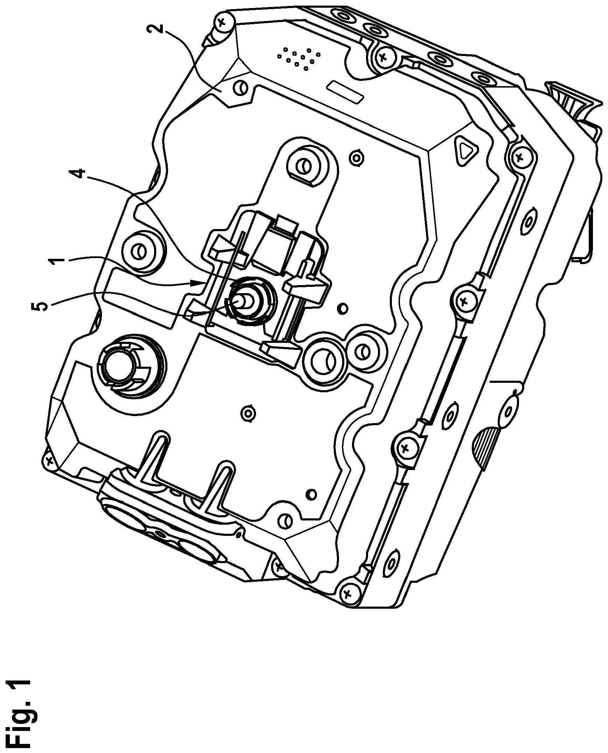

Im Folgenden wird anhand der Figuren 1 bis 5 ein Ausführungsbeispiel der elektrischen Kontaktanordnung 1 im Detail beschrieben.

Gemäß Figur 1 umfasst die Kontaktanordnung 1 ein Gehäuse 2. In dem Gehäuse 2 befindet sich beispielsweise eine Leistungselektronik. Das Gehäuse 2 wird insbesondere in einem Kraftfahrzeug eingebaut und ist Umwelteinflüssen, wie beispielsweise Wasser, ausgesetzt. In dem Gehäuse sitzt eine Buchse 4 aus Kunststoff in einer Aussparung 3. In dieser Buchse 4 ist ein Kontaktbolzen 5 aus Metall fest eingesetzt. Sowohl die Buchse 4 als auch der Kontaktbolzen 5 ragen aus dem Gehäuse 2 heraus. Zur Befestigung der Buchse 4 gegenüber dem Gehäuse 2 wird ein Befestigungselement 6 verwendet.

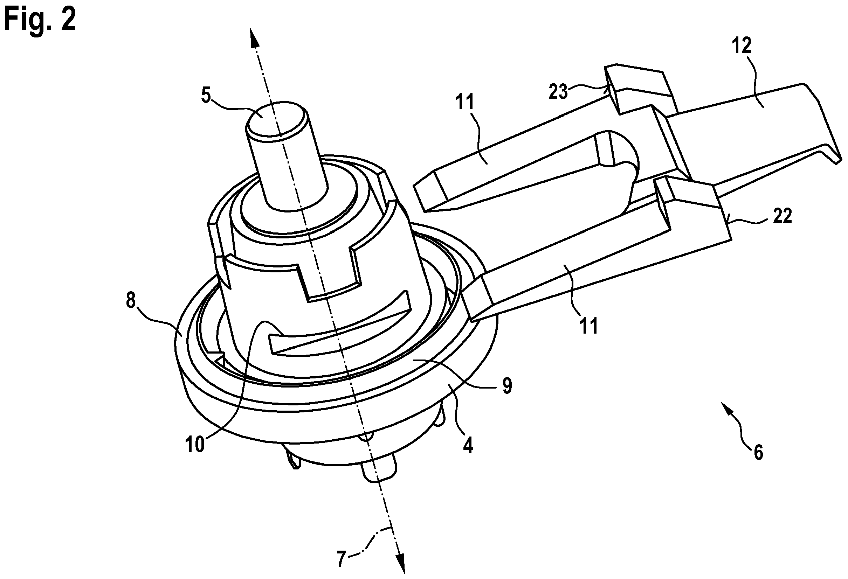

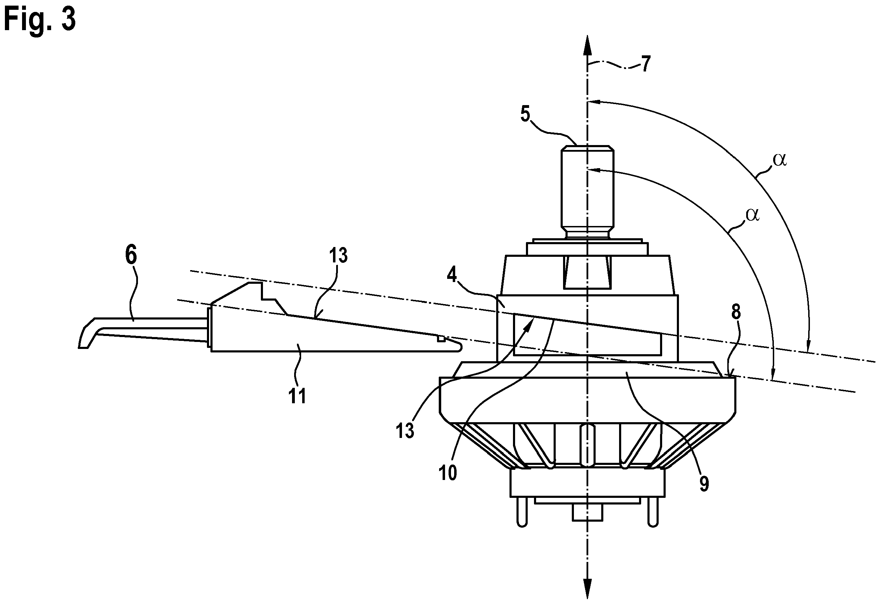

Die Figuren 2 und 3 zeigen in unterschiedlichen Ansichten die Verwendung der Buchse 4 und des Befestigungselementes 6 im Detail. Die Erstreckung des Kontaktbolzens 5 definiert eine Axialrichtung 7. An der Buchse 4 ist eine axiale Dichtfläche 8 ausgebildet. Auf dieser axialen Dichtfläche 8 sitzt eine ringförmige Dichtung 9. Zur Abdichtung der Buchse 4 gegenüber dem Gehäuse 2 muss diese Dichtfläche 8 mit der Dichtung 9 von Innen gegen das Gehäuse 2 gepresst werden. Hierzu wird das Befestigungselement 6 verwendet.

Die Buchse 4 weist außerhalb des Gehäuses 2 zwei Absätze 10 in zwei Nuten auf. Die Absätze 10 und somit die Nuten verlaufen parallel zueinander und beidseitig des Kontaktbolzens 5. Das Befestigungselement 6 ist gabelförmig ausgestaltet. Hierzu umfasst das Befestigungselement 6 zwei parallele Finger 11. Diese beiden Finger 11 sind über eine Basis 12 miteinander verbunden. Am Befestigungselement 6 sind zwei Montageflächen 22 vorgesehen. An diesen Montageflächen 22 kann ein Werkzeug angreifen, um das Befestigungselement 6 in die Nuten zu schieben. Besonders bevorzugt gibt es gegenüber den Montageflächen 22 Demontageflächen 23, um gegebenenfalls das Befestigungselement 6 wieder aus den Nuten herauszuziehen.

Die beiden Finger 11 des Befestigungselementes 6 weisen keilförmige Flächen 13 auf. Diese Flächen 13 können auch als geneigte Flächen bezeichnet werden. Einer jeden keilförmigen Fläche 13 der Finger 11 liegt eine entsprechende keilförmige Fläche 13 am Absatz 10 innerhalb der jeweiligen Nut gegenüber. Insbesondere Figur 3 zeigt die Neigung der keilförmigen Flächen 13 gegenüber der Axialrichtung 7. Die Neigung α liegt hier vorteilhafterweise zwischen 95° und 120°.

Durch Einschieben des Befestigungselementes 6 unter die Absätze 10 und dadurch, dass das Befestigungselement 6 auf dem Gehäuse 2 aufliegt, wird die Buchse 4 samt Kontaktbolzen 5 in Axialrichtung 7 nach außen gezogen. Dadurch presst sich die Dichtfläche 8 von Innen gegen das Gehäuse 2.

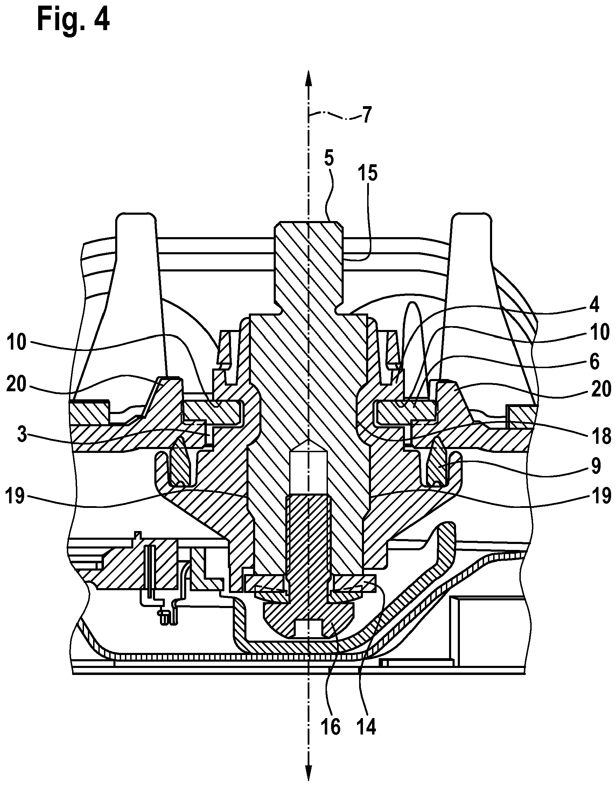

Figur 4 zeigt einen Schnitt durch die Kontaktanordnung 1. Anhand von Figur 4 ist zu erkennen, dass der Kontaktbolzen 5 eine Verjüngung 18 aufweist. Unterhalb der Verjüngung 18 ist ein Mehrkant 19 ausgebildet. Sowohl die Verjüngung 18 als auch der Mehrkant 19 sind vom Kunststoff der Buchse 4 umspritzt. Die Verjüngung 18 sorgt für einen Formschluss in Axialrichtung 7. Der Mehrkant 19 verhindert ein Verdrehen um die Axialrichtung 7.

An der Innenseite ist der Kontaktbolzen 5 mit einer Stromschiene 14 elektrisch leitend verbunden. Hierzu ist in Axialrichtung 7 eine entsprechende Verschraubung 16 gesetzt.

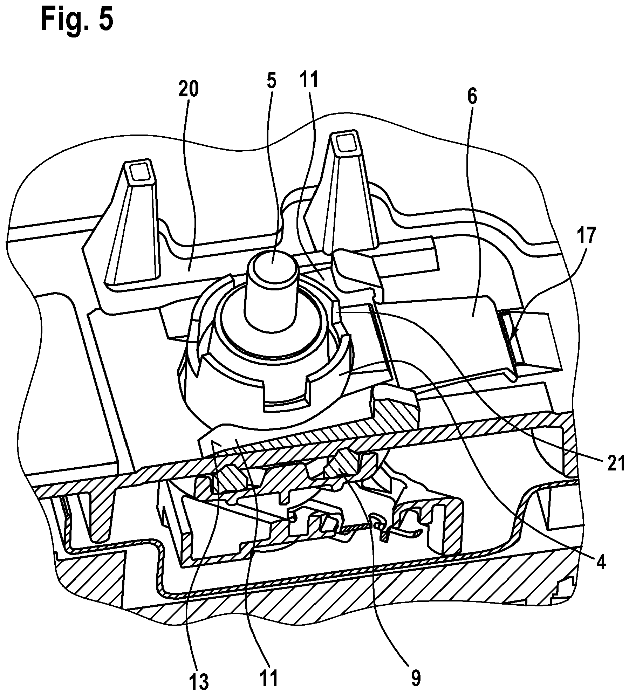

Figuren 4 und 5 zeigen, dass das Befestigungselement 6, insbesondere die beiden Finger 11, mit ihren äußeren Kanten an Schultern 20 des Gehäuses 2 anliegen. Aufgrund dieses Formschlusses gegenüber der Schultern 20 wird ein Verdrehen des Befestigungselementes 6 um die Axialrichtung 7 vermieden. Dadurch ist auch gleichzeitig die Buchse 4 samt Kontaktbolzen 5 verdrehsicher aufgenommen. Das äußere Ende des Kontaktbolzens 5 weist vorteilhafterweise ein Gewinde 15 auf. Beim Aufschrauben einer Mutter auf dieses Gewinde 15 stützt sich somit das auftretende Drehmoment über die Schultern 20 gegenüber dem Gehäuse 2 ab.

Figur 5 zeigt eine vorteilhafte Rastverbindung 17 zwischen dem Befestigungselement 6 und dem Gehäuse 2. Hierzu weist das Gehäuse 2 eine entsprechende Nase oder Kante auf, hinter die das Befestigungselement 6 einrastet.

Das aus dem Gehäuse 2 herausstehende Ende der Buchse 4 ist im Ausführungsbeispiel vorteilhafterweise als Krone ausgestaltet. Diese Krone weist Öffnungen 21 auf. Auf den Kontaktbolzen 5 wird vorteilhafterweise ein Polschuh befestigt. Dieser Polschuh ist üblicherweise von einem Gehäuse oder Deckel umgeben. Dieser Deckel oder dieses Gehäuse können formschlüssig und somit verdrehsicher und lagegenau in den Öffnungen 21 sitzen.

## Patentansprüche

1. Elektrische Kontaktanordnung (1), umfassend
• ein Gehäuse (2) mit einer das Gehäuse (2) in Axialrichtung (7) durchbrechenden Aussparung (3),
• eine in die Aussparung (3) eingesetzte Buchse (4)
o mit einer axialen Dichtfläche (8) im Inneren des Gehäuses (2) und
o mit zwei senkrecht zur Axialrichtung (7) verlaufenden Absätzen(10), vorzugsweise in Nuten, außerhalb des Gehäuses (2),
• einen Kontaktbolzen (5), der fest in der Buchse (4) angeordnet ist und durch die Buchse (4) hindurchragt,
• ein Befestigungselement (6), das zum Aufliegen auf dem Gehäuse (2) und zum Einschieben unter die Absätze (10) ausgebildet ist, **dadurch gekennzeichnet, dass**
• keilförmige Flächen (13) zwischen der Buchse (4) und dem Befestigungselement (6) und/oder zwischen dem Gehäuse (2) und dem Befestigungselement (6), so dass durch Einschieben des Befestigungselementes (6) unter die Absätze (10) die Dichtfläche (8) von Innen gegen das Gehäuse (2) ziehbar ist.

2. Kontaktanordnung (1) nach Anspruch 1, **dadurch gekennzeichnet, dass** das Befestigungselement (6) gabelförmig ausgestaltet ist, indem es zwei miteinander verbundene, parallele Finger (11) zum Einschieben unter die Absätze (10) umfasst.

3. Kontaktanordnung (1) nach einem der vorhergehenden Ansprüche, **dadurch gekennzeichnet, dass** die keilförmigen Flächen (13) auf den Fingern (11) und an den Absätzen (10), insbesondere in den Nuten, ausgebildet sind.

4. Kontaktanordnung (1) nach einem der vorhergehenden Ansprüche, **dadurch gekennzeichnet, dass** der Kontaktbolzen (5) durch einen Formschluss verdrehsicher in der Buchse (4) angeordnet ist.

5. Kontaktanordnung (1) nach einem der vorhergehenden Ansprüche, **dadurch gekennzeichnet, dass** die Buchse (4) aus Kunststoff hergestellt ist, und der Kontaktbolzen (5) vom Kunststoff der Buchse (4) umspritzt ist.

6. Kontaktanordnung (1) nach einem der vorhergehenden Ansprüche, **dadurch gekennzeichnet, dass** das Befestigungselement (6) durch einen Formschluss verdrehsicher am Gehäuse (2) anliegt.

7. Kontaktanordnung (1) nach einem der vorhergehenden Ansprüche, **dadurch gekennzeichnet, dass** eine Neigung der keilförmigen Flächen (13) für einen selbsthemmenden Halt des Befestigungselementes (6) gewählt ist.

8. Kontaktanordnung (1) nach einem der vorhergehenden Ansprüche, **gekennzeichnet durch** eine Rastverbindung (17) zwischen dem Befestigungselement (6) und dem Gehäuse (2) zur Fixierung des eingeschobenen Befestigungselementes (6).

9. Kontaktanordnung (1) nach einem der vorhergehenden Ansprüche, **dadurch gekennzeichnet, dass** auf der Dichtfläche (8) eine ringförmige Dichtung (9) angeordnet ist.

10. Anordnung für eine Fahrzeug, umfassend zumindest eine elektrische Kontaktanordnung (1) nach einem der vorhergehende Ansprüche, wobei im Gehäuse (2) ein Steuergerät, eine Leistungselektronik, ein Energiespeicher und/oder eine elektrische Maschine angeordnet ist/sind.

## Claims

1. Electrical contact arrangement (1) comprising
• a housing (2) having a cutout (3) that penetrates the housing (2) in the axial direction (7),
• a bushing (4) inserted into the cutout (3), said bushing (4)
o having an axial sealing surface (8) in the interior of the housing (2) and
o having two ledges (10) extending perpendicularly to the axial direction (7), preferably in grooves, outside the housing (2),
• a contact pin (5) which is arranged fixedly in the bushing (4) and projects through the bushing (4),
• a fastening element (6) which is configured to rest on the housing (2) and to be introduced under the ledges (10), **characterized in that**
• wedge-shaped surfaces (13) between the bushing (4) and the fastening element (6) and/or between the housing (2) and the fastening element (6), such that, as a result of the fastening element (6) being introduced under the ledges (10), the sealing surface (8) is able to be drawn against the housing (2) from the inside.

2. Contact arrangement (1) according to Claim 1, **characterized in that** the fastening element (6) is configured in a fork-shaped manner by comprising two mutually connected, parallel fingers (11) for introduction under the ledges (10).

3. Contact arrangement (1) according to either of the preceding claims, **characterized in that** the wedge-shaped surfaces (13) are formed on the fingers (11) and on the ledges (10), in particular in the grooves.

4. Contact arrangement (1) according to one of the preceding claims, **characterized in that** the contact pin (5) is arranged in the bushing (4) in a rotation-proof manner by way of a form fit.

5. Contact arrangement (1) according to one of the preceding claims, **characterized in that** the bushing (4) is produced from plastics material and the contact pin (5) is encapsulated by the plastics material of the bushing (4).

6. Contact arrangement (1) according to one of the preceding claims, **characterized in that** the fastening element (6) rests on the housing (2) in a rotation-proof manner by way of a form fit.

7. Contact arrangement (1) according to one of the preceding claims, **characterized in that** an inclination of the wedge-shaped surfaces (13) is selected for a self-locking hold of the fastening element (6).

8. Contact arrangement (1) according to one of the preceding claims, **characterized by** a latching connection (17) between the fastening element (6) and the housing (2) for fixing the introduced fastening element (6).

9. Contact arrangement (1) according to one of the preceding claims, **characterized in that** an annular seal (9) is arranged on the sealing surface (8).

10. Arrangement for a vehicle, comprising at least one electrical contact arrangement (1) according to one of the preceding claims, wherein a control unit, power electronics, an energy store and/or an electric machine is/are arranged in the housing (2).

## Revendications

1. Agencement de contact électrique (1), comprenant :
- un boîtier (2) avec un évidement (3) traversant le boîtier (2) dans la direction axiale (7),
- une douille (4) insérée dans l'évidement (3),
- avec une surface d'étanchéité axiale (8) à l'intérieur du boîtier (2) et
- avec deux épaulements (10) s'étendant perpendiculairement à la direction axiale (7), de préférence dans des rainures, à l'extérieur du boîtier (2),
- un goujon de contact (5) qui est disposé fixement dans la douille (4) et qui fait saillie à travers la douille (4),
- un élément de fixation (6) qui est réalisé pour s'appliquer sur le boîtier (2) et pour s'insérer sous les épaulements (10),
**caractérisé en ce que**
- des surfaces en forme de cale (13) entre la douille (4) et l'élément de fixation (6) et/ou entre le boîtier (2) et l'élément de fixation (6), de telle sorte que par insertion de l'élément de fixation (6) sous les épaulements (10), la surface d'étanchéité (8) puisse être tirée depuis l'intérieur contre le boîtier (2).

2. Agencement de contact (1) selon la revendication 1, **caractérisé en ce que** l'élément de fixation (6) est réalisé en forme de fourche par le fait qu'il comprend deux doigts parallèles (11) connectés l'un à l'autre pour l'insertion sous les épaulements (10).

3. Agencement de contact (1) selon l'une quelconque des revendications précédentes, **caractérisé en ce que** les surfaces en forme de cale (13) sont réalisées sur les doigts (11) et sur les épaulements (10), en particulier dans les rainures.

4. Agencement de contact (1) selon l'une quelconque des revendications précédentes, **caractérisé en ce que** le goujon de contact (5) est disposé par engagement par correspondance de formes de manière solidaire en rotation dans la douille (4).

5. Agencement de contact (1) selon l'une quelconque des revendications précédentes, **caractérisé en ce que** la douille (4) est fabriquée en plastique et le goujon de contact (5) est surmoulé à partir du plastique de la douille (4).

6. Agencement de contact (1) selon l'une quelconque des revendications précédentes, **caractérisé en ce que** l'élément de fixation (6) s'applique par engagement par correspondance de formes de manière solidaire en rotation sur le boîtier (2).

7. Agencement de contact (1) selon l'une quelconque des revendications précédentes, **caractérisé en ce qu'**une inclinaison des surfaces en forme de cale (13) est sélectionnée pour retenir de manière autobloquante l'élément de fixation (6).

8. Agencement de contact (1) selon l'une quelconque des revendications précédentes, **caractérisé par** une connexion par encliquetage (17) entre l'élément de fixation (6) et le boîtier (2) pour la fixation de l'élément de fixation enfoncé (6).

9. Agencement de contact (1) selon l'une quelconque des revendications précédentes, **caractérisé en ce qu'**un joint d'étanchéité annulaire (9) est disposé sur la surface d'étanchéité (8).

10. Agencement pour un véhicule, comprenant au moins un agencement de contact électrique (1) selon l'une quelconque des revendications précédentes, dans lequel un appareil de commande, une électronique de puissance, un accumulateur d'énergie et/ou une machine électrique est/sont disposés dans le boîtier (2).
